# EUROPEAN PATENT APPLICATION

(11) **EP 4 529 399 A1**
(43) Date of publication of application: **26.03.2025**
(21) Application number: 24201782.0
(22) Date of filing: 20.09.2024
(51) Int. Cl.: H10K 59/131, H10K 59/65, H10K 59/80

(54) **ELECTRONIC DEVICE**

(30) Priority: 22.09.2023 KR 20230127371
(71) Applicant: Samsung Display Co., Ltd., Gyeonggi-do 17113 (KR)
(72) Inventor: KIM, IN WOO, 17113 Yongin-si (KR)
(74) Representative: Taor, Simon Edward William

(57) **Abstract**

Provided is an electronic device including a display module defining a module hole, and including a base layer including a first region surrounded by a second region in plan view, pixels in the second region, data lines connected to the pixels, and dam patterns in the first region and surrounding the module hole in plan view, the dam patterns including a first pattern above the base layer, a lower layer above the first pattern, a second pattern above the lower layer and including a same material as the data lines, and an upper layer above the second pattern and defining an opening exposing a portion of the second pattern, a window above the display module, and an electronic module below the display module, overlapping the first region, and overlapping the module hole.

## Description

### CROSS-REFERENCE TO RELATED APPLICATIONS

The present application claims priority to, and the benefit of, Korean Patent Application No. 10-2023-0127371, filed on September 22, 2023.

### BACKGROUND

### 1. Field

The present disclosure herein relates to an electronic device having improved quality.

### 2. Description of the Related Art

An electronic device is activated according to an electrical signal. The electronic device may include devices composed of various electronic components, such as a display panel configured to display an image and an input sensor configured to sense a user's input. The electronic components may be electrically connected to each other by variously arranged signal lines.

### SUMMARY

The present disclosure provides an electronic device with improved quality.

One or more embodiments of the present disclosure provide an electronic device including a display module defining a module hole, and including a base layer including a first region surrounded by a second region in plan view, pixels in the second region, data lines connected to the pixels, and dam patterns in the first region and surrounding the module hole in plan view, the dam patterns including a first pattern above the base layer, a lower layer above the first pattern, a second pattern above the lower layer and including a same material as the data lines, and an upper layer above the second pattern and defining an opening exposing a portion of the second pattern, a window above the display module, and an electronic module below the display module, overlapping the first region, and overlapping the module hole.

A thickness of the upper layer may be less than a thickness of the lower layer, wherein at least one of opposing sides of the second pattern protrudes between the lower layer and the upper layer.

The display module may further include an encapsulation layer covering the pixels and including a first inorganic encapsulation layer, a second inorganic encapsulation layer above the first inorganic encapsulation layer, and an organic encapsulation layer between the first inorganic encapsulation layer and the second inorganic encapsulation layer.

The first inorganic encapsulation layer may cover a side surface of the lower layer, a portion of the second pattern protruding between the lower layer and the upper layer, and the side surface and upper surface of the upper layer.

The organic encapsulation layer may have a boundary defined by any one of the dam patterns in the first region.

The lower layer may define a contact hole exposing at least a portion of the first pattern, wherein the second pattern is in the contact hole and contacts the first pattern.

The pixels may include a transistor, and a light-emitting element including a first electrode connected to the transistor, a second electrode above the first electrode, and a common layer between the first electrode and the second electrode.

The electronic device may further include a first floating pattern between the dam patterns adjacent to each other, including a same material as the common layer, and disconnected from the common layer.

The electronic device may further include a second floating pattern above the upper layer, disconnected from the first floating pattern and the common layer, and including a same material as the common layer.

Lower layers included in dam patterns spaced apart from each other with the first floating pattern interposed therebetween may be connected to each other, and the first floating pattern may be disposed on the connected lower layers.

The electronic device may further include a blocking pattern between the dam patterns and dividing the first floating pattern.

The blocking pattern may include a first layer, a second layer above the first layer, and including a material that is different from a material of the first layer, and a third layer above the second layer, and including the material of the first layer, wherein the first layer and the third layer protrude in a direction toward the dam patterns further than the second layer.

The blocking pattern may be provided in plurality, the blocking patterns being spaced apart from each other and surrounding the module hole.

The blocking pattern may be above connected lower layers of the dam patterns spaced apart from each other with the first floating pattern therebetween.

The second pattern and the data lines may include a first layer including titanium, a second layer including aluminum above the first layer, and a third layer including titanium above the second layer.

At least one of opposing sides of the second pattern may protrude between the lower layer and the upper layer, wherein the first layer and the third layer protrude in a direction toward the dam patterns further than the second layer.

The second pattern may define a hole overlapping the opening, having a groove corresponding to a removed portion of the second layer, and having a pattern opening passing through the third layer and overlapping the groove.

The hole may expose a lower surface of the third layer adjacent to the pattern opening.

The pixels may include a light-emitting element connected to a transistor including an active pattern and a gate overlapping the active pattern, wherein one of the dam patterns is below and overlaps the first pattern, and further includes a dummy pattern including a same material as the gate or the active pattern.

The display module may include a display panel including the base layer and the pixels, an input sensor above the display panel for sensing a user's input, an organic cover layer above the input sensor, and an anti-reflective layer between the organic cover layer and the window.

According to an aspect, there is provided an electronic device as set out in claim 1. Additional features are set out in claims 2 to 15.

### BRIEF DESCRIPTION OF THE DRAWINGS

The accompanying drawings are included to provide a further understanding of the disclosed embodiments, and are incorporated in and constitute a part of this specification. The drawings illustrate embodiments of the present disclosure and, together with the description, serve to explain aspects of the present disclosure. In the drawings:
FIG. 1 is a perspective view of an electronic device according to one or more embodiments of the present disclosure;
FIG. 2 is an exploded perspective view of the electronic device according to one or more embodiments of the present disclosure;
FIG. 3 is a block diagram of the electronic device according to one or more embodiments of the present disclosure;
FIG. 4 is an enlarged view illustrating a region XX' of FIG. 2;
FIG. 5 is a cross-sectional view taken along the line I-I' of FIG. 2;
FIG. 6A is a cross-sectional view taken along the line II-II' of FIG. 2;
FIG. 6B is an enlarged view of one dam pattern illustrated in FIG. 6A;
FIGS. 7 to 14 are cross-sectional views illustrating a portion of a first region of a display module according to one or more embodiments of the present disclosure; and
FIGS. 15A to 15H are plan views illustrating a manufacturing method for forming a dam pattern according to one or more embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

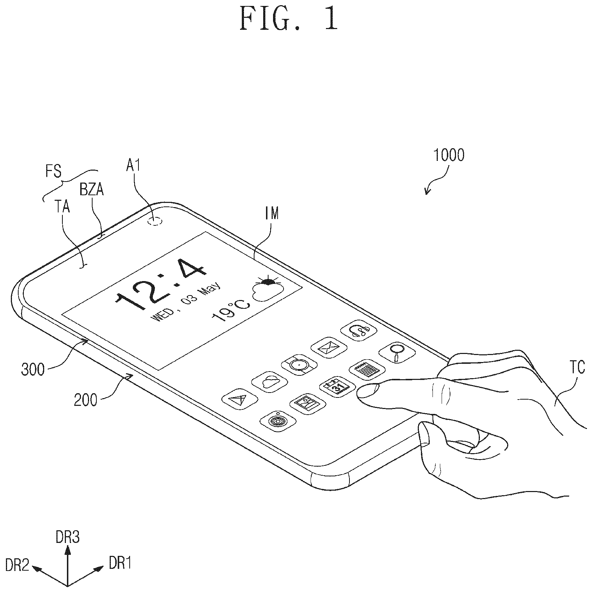

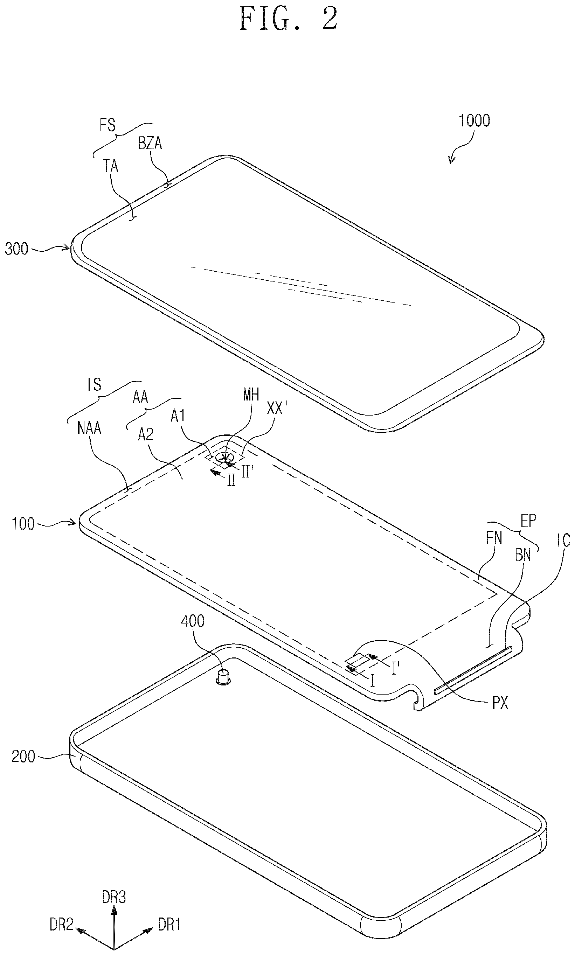

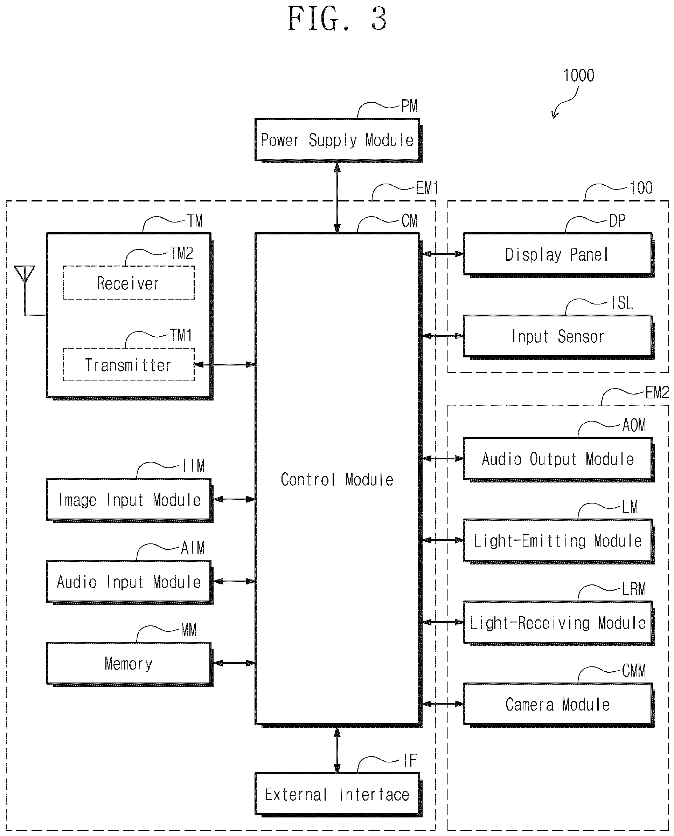

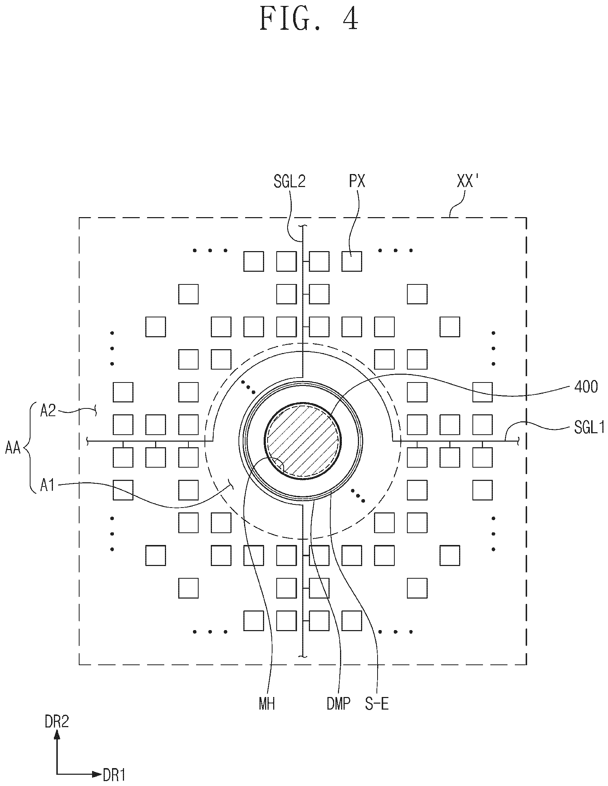

FIG. 1 is a perspective view of an electronic device according to one or more embodiments of the present disclosure. FIG. 2 is an exploded perspective view of the electronic device according to one or more embodiments of the present disclosure. FIG. 3 is a block diagram of the electronic device according to one or more embodiments of the present disclosure. FIG. 4 is an enlarged view illustrating a region XX' of FIG. 2.

Referring to FIGS. 1 and 2, the electronic device 1000 may display an image IM in a third direction DR3 on a display surface FS parallel to each of first and second directions DR1 and DR2. The display surface FS on which an image IM is displayed may correspond to the front surface of the electronic device 1000.

The display surface FS of the electronic device 1000 may be provided from a front surface FS of a window 300. Accordingly, the display surface FS of the electronic device 1000 and the front surface FS of the window 300 may use the same reference numeral. An image IM displayed on the display surface FS may include a still image as well as a dynamic image. FIG. 1 illustrates a clock and a plurality of icons as an example of an image IM.

The front (or upper) and rear (or lower) surfaces of each member are defined based on the direction in which an image IM is displayed. The front and rear surfaces are opposed to each other in the third direction DR3, and the normal direction of each of the front and rear surfaces may be parallel to the third direction DR3. The separation distance between the front and rear surfaces of the electronic device 1000 (or a corresponding member thereof) in the third direction DR3 may correspond to the thickness of the electronic device 1000 (or the member) in the third direction DR3.

The electronic device 1000 according to one or more embodiments of the present disclosure may sense a user's input TC applied from the outside. The user's input TC includes various types of external inputs such as a part of a user's body, light, heat, or pressure. The user's input TC is illustrated as the user's hand applied to the front surface FS of the window 300.

However, this is illustrated as an example, and as described above, the user's input TC may be provided in various forms, and the electronic device 1000 may also sense the user's input TC applied to the side or rear surface thereof, and embodiments of the present disclosure are not limited.

The electronic device 1000 according to one or more embodiments of the present disclosure may include a first region A1 that overlaps a light transmission region TA. The first region A1 may be defined as a region that overlaps an electronic module 400 located below a display module 100, which will be described later. The first region A1 may include a module hole MH (see FIG. 2) that is defined through the display module 100, and that overlaps the electronic module 400.

The electronic device 1000 may receive a user's signal suitable for the electronic module 400 through the first region A1, or may provide a signal output from the electronic module 400 to the outside. According to the present disclosure, by providing the first region A1 inside the light transmission region TA, the area of the bezel region BZA may be reduced.

Referring to FIG. 2, the electronic device 1000 may include a display module 100, a housing 200, a window 300, and an electronic module 400. The window 300 and the housing 200 are coupled to each other to form the exterior of the electronic device 1000.

The window 300 may include an insulating panel. For example, the window 300 may be composed of glass, plastic, or a combination thereof. As described above, the front surface FS of the window 300 defines the front surface FS of the electronic device 1000. The window 300 may include a light transmission region TA and a bezel region BZA adjacent to the light transmission region TA. The light transmission region TA may be an optically transparent region. For example, the light transmission region TA may have a visible light transmittance of about 90% or more. The bezel region BZA may have a relatively low light transmittance, as compared to the light transmission region TA. The bezel region BZA defines the shape of the light transmission region TA.

The bezel region BZA may have a color (e.g., predetermined color). The bezel region BZA may be defined by a transparent substrate defining the light transmission region TA, and a separately provided bezel layer, or by an ink layer formed by inserting into or coating the transparent substrate.

The display module 100 may include an electronic panel EP and a driving circuit IC. The electronic panel EP may display an image IM, and may sense a user's input TC. The front surface IS of the electronic panel EP includes an active region AA and a peripheral region NAA. The active region AA may be activated according to an electrical signal.

The active region AA may be a region in which an image IM is displayed, and may also be a region in which a user's input TC is sensed. The active region AA may be a region in which a plurality of pixels PX are located.

According to the present disclosure, the active region AA may include a first region A1, and a second region A2 surrounding at least a portion of the first region A1 (e.g., in plan view). The pixels PX may be located in the second region A2 of the active region AA. A module hole MH passing through the electronic panel EP from the front surface IS to the rear surface thereof may be defined in the first region A1. The electronic module 400 located below the electronic panel EP may overlap the module hole MH defined in the first region A1.

The active region AA overlaps at least a portion of the light transmission region TA. For example, the light transmission region TA overlaps the entire surface of, or at least a portion of, the active region AA. Accordingly, a user may view an image IM, or may provide a user's input TC through the light transmission region TA. However, this is illustrated as an example, and in the active region AA, a region in which the image IM is displayed and a region in which the external input TC is sensed may be separated from each other, and embodiments of the present disclosure are not limited.

The peripheral region NAA may be covered by the bezel region BZA. The peripheral region NAA is adjacent to the active region AA. The peripheral region NAA may surround the active region AA (e.g., in plan view). The peripheral region NAA may be a region in which an image IM is not displayed. A driving circuit, a driving line, or the like for driving the active region AA may be located in the peripheral region NAA.

In one or more embodiments, a portion of the peripheral region NAA of the electronic panel EP may be bent. For example, the electronic panel EP may include a flat portion FN and a bending portion BN. The flat portion FN may be assembled in a state in which the flat portion FN is substantially parallel to a plane defined by the first direction DR1 and the second direction DR2. The active region AA may be provided in the flat portion FN.

The bending portion BN may extend from the flat portion FN, and may be bent along a virtual bending axis. The bending portion BN may be assembled by being bent so as to face the rear surface of the flat portion FN. If the bending portion BN is assembled, the bending portion BN overlaps the flat portion FN on a plane, and therefore, the bezel region BZA of the electronic device 1000 may be reduced. Meanwhile, this is illustrated as an example, and in the electronic panel EP, the bending portion BN may be omitted.

The driving circuit IC may be mounted on the bending portion BN. One or more embodiments are illustrated in which the driving circuit IC is provided in the form of a chip, but embodiments of the present disclosure are not limited thereto, and the driving circuit IC may be provided on a separate circuit board and electrically connected to the electronic panel EP through a flexible film or the like.

The driving circuit IC is electrically connected to the active region AA, and transmits an electrical signal to the active region AA. For example, the driving circuit IC may include a data-driving circuit, and may provide data signals to the pixels PX located in the active region AA. Alternatively, the driving circuit IC may include a touch-driving circuit, and may be electrically connected to an input sensor located in the active region AA. Meanwhile, this is described as an example, and the driving circuit IC may be designed to include various circuits in addition to the above-described circuits or provide various electrical signals to the active region AA, and embodiments of the present disclosure are not limited.

The electronic device 1000 according to one or more embodiments of the present disclosure may further include a main circuit board electrically connected to the electronic panel EP and the driving circuit IC. The main circuit board may include various driving circuits for driving the electronic panel EP, a connector for power supply, or the like. The main circuit board may be a rigid printed circuit board PCB, but embodiments are not limited thereto and may also be a flexible circuit board, and embodiments of the present disclosure are not limited.

The electronic module 400 is located below the display module 100. The electronic module 400 may overlap the module hole MH defined in the electronic panel EP, and may receive a user's input transmitted through the module hole MH, or may output a signal through the module hole MH.

FIG. 2 illustrates a single module hole MH having a circular shape as an example, but embodiments of the present disclosure are not limited thereto, and the number of the module hole(s) MH may be defined in the electronic panel EP so as to correspond to the number of the electronic module(s) 400 located below the electronic panel EP, and the module hole MH may have any one of a polygonal shape and an oval shape and is not limited.

According to the present disclosure, by providing the first region A1 having a relatively high transmittance inside the active region AA, the electronic module 400 may overlap the active region AA. Accordingly, it is possible to reduce the size of the bezel region BZA.

The housing 200 may be coupled to the window 300 to provide an internal space (e.g., a predetermined internal space), and may define the exterior of the electronic device 1000. The components of the electronic device 1000, such as the display module 100 and the electronic module 400, may be accommodated in the internal space.

The housing 200 may include a material with relatively high rigidity. For example, the housing 200 may include a plurality of frames and/or plates made of glass, plastic, or metal, or a combination thereof. The housing 200 may stably protect the components of the electronic device 1000 accommodated in the internal space from a user's impact.

Referring to FIG. 3, the electronic device 1000 may include a display module 100, a power supply module PM, a first electronic module EM1, and a second electronic module EM2. The display module 100, the power supply module PM, the first electronic module EM1, and the second electronic module EM2 may be electrically connected to each other.

FIG. 3 illustrates the display panel DP and the input sensor ISL of the display module 100. The display panel DP may be configured to generate an image IM. The image IM generated by the display panel DP is displayed on the display surface FS through the light transmission region TA, and is viewed by a user from the outside. The input sensor ISL senses a user's input TC applied from the outside. As described above, the input sensor ISL may sense the external input TC provided to the window 300.

The power supply module PM supplies power suitable for the overall operation of the electronic device 1000. The power supply module PM may include a conventional battery module.

The first electronic module EM1 and the second electronic module EM2 include various functional modules for operating the electronic device 1000. The first electronic module EM1 may be mounted directly on the motherboard electrically connected to the electronic panel EP, or may be mounted on a separate board and electrically connected to the motherboard through a connector or the like, in one or more embodiments.

The first electronic module EM1 may include a control module CM, a wireless communication module TM, an image input module IIM, an audio input module AIM, a memory MM, and a user's interface IF. Some of the modules may not be mounted on the motherboard, but may be electrically connected to the motherboard through a flexible printed circuit board.

The control module CM controls the overall operation of the electronic device 1000. The control module CM may be a microprocessor. For example, the control module CM activates or deactivates the display module 100. The control module CM may control other modules, such as an image input module IIM or an audio input module AIM, based on a touch signal received from the electronic panel EP.

The wireless communication module TM may transmit/receive a wireless signal to/from another terminal by using a Bluetooth or Wi-Fi line. The wireless communication module TM may transmit/receive a voice signal by using a general communication line. The wireless communication module TM includes a transmitter TM1, which modulates a signal to be transmitted and transmits the modulated signal, and a receiver TM2, which demodulates the received signal.

The image input module IIM processes image signals, and converts them into image data that may be displayed on the electronic panel EP. The audio input module AIM receives external audio signals through a microphone in a recording mode, a voice recognition mode, or the like, and converts them into electrical voice data.

The external interface IF serves as an interface connected to a user's charger, a wired/wireless data port, a card socket (e.g., a memory card or a SIM/UIM card), and the like.

The second electronic module EM2 may include an audio output module AOM, a light-emitting module LM, a light-receiving module LRM, and a camera module CMM. The above components may be mounted directly on the motherboard, or may be mounted on a separate board and electrically connected to the electronic panel EP through a connector, or may be electrically connected to the first electronic module EM1, in one or more embodiments.

The audio output module AOM converts audio data received from the wireless communication module TM, or audio data stored in the memory MM, and outputs the audio data to the outside.

The light-emitting module LM generates and outputs light. The light-emitting module LM may output infrared rays. The light-emitting module LM may include an LED element. The light-receiving module LRM may detect infrared rays. The light-receiving module LRM may be activated when infrared rays of a corresponding level (e.g., a predetermined level) or higher are detected. The light-receiving module LRM may include a CMOS sensor. After infrared light generated in the light-emitting module LM is output, the infrared light is reflected by a user's object (e.g., a user's finger or face), and the reflected infrared light may be incident on the light-receiving module LRM. The camera module CMM captures a user's image.

The electronic module 400 according to one or more embodiments of the present disclosure may include at least any one of the components of the second electronic module EM2. For example, the electronic module 400 may include at least one of a camera, a speaker, a light sensor, or a heat sensor. The electronic module 400 may detect a user's subject received through the first region A1, or may provide a sound signal, such as a voice, to the outside through the first region A1. In addition, the electronic module 400 may include a plurality of components, and is not particularly limited. In one or more embodiments, the electronic module 400 may be attached to the electronic panel EP by a separate adhesive.

FIG. 4 illustrates a portion XX' of the active region AA adjacent to the module hole MH among the display panel DP (see FIG. 3) included in the display module 100.

Referring to FIG. 4, most of the pixels PX included in the display panel DP may be located in the second region A2, and some of the pixels PX may be located in the second region A2 along the boundary between the first region A1 and the second region A2, and may be spaced apart from the first region A1.

The module hole MH may be defined in the active region AA. Accordingly, at least some of the pixels PX may be adjacent to the module hole MH, and may be spaced apart from each other with the module hole MH interposed therebetween. The electronic module 400 may overlap the module hole MH.

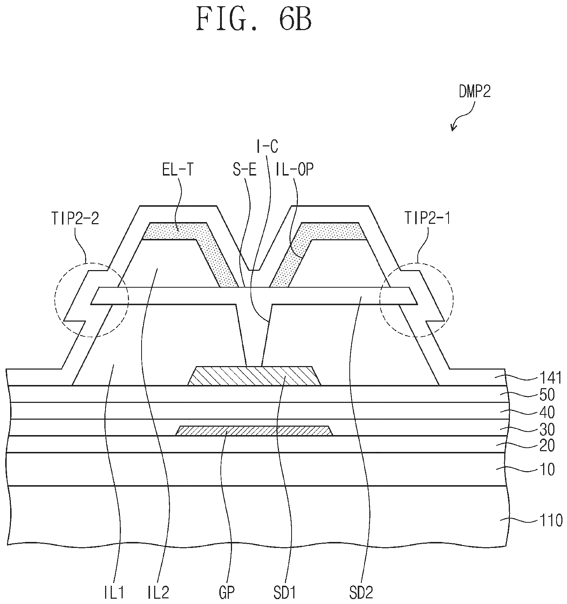

At least one dam pattern DMP may be located in the first region A1 of the display panel DP. The electronic device 1000 (see FIG. 2) according to one or more embodiments of the present disclosure may block a path through which moisture and/or oxygen flows from the module hole MH to the pixels PX by using the dam pattern DMP. In the dam pattern DMP according to the present disclosure, on a plane, an upper layer IL2 (see FIG. 6B) included in the dam pattern DMP may expose a portion S-E of a second pattern SD2 (see FIG. 6B) included in the dam pattern DMP. An explanation regarding this will be provided later.

The dam pattern DMP may be located in the first region A1, and may surround at least a portion of the module hole MH. According to one or more embodiments of the present disclosure, on a plane, the dam pattern DMP may have a closed-line shape surrounding the module hole MH.

According to one or more embodiments of the present disclosure, a filler may be located inside the module hole MH. The filler may include a polymer resin. As the filler is located inside the module hole MH, a flat surface may be provided to a component located on the module hole MH.

A portion of each of a plurality of signal lines SGL1 and SGL2 connected to the pixels PX may be located in the first region A1. The signal lines SGL1 and SGL2 are connected to the pixels PX spaced apart from each other with the module hole MH interposed therebetween via the first region A1. For ease of explanation, FIG. 4 illustrates two signal lines SGL1 and SGL2 among the plurality of signal lines connected to the pixels PX.

A first signal line SGL1 extends along the first direction DR1. The first signal line SGL1 is connected to pixels in a same row arranged along the first direction DR1 among the pixels PX. The first signal line SGL1 is explained as corresponding to any one of scan lines connected to the pixels PX.

Some of the pixels PX connected to the first signal line SGL1 are located on the left side of the module hole MH, and others are located on the right side of the module hole MH. Accordingly, the pixels PX in the same row, which are connected to the first signal line SGL1, may be substantially turned on/off by a same scan signal although some pixels centered around the module hole MH are omitted.

A second signal line SGL2 extends along the second direction DR2. The second signal line SGL2 is connected to pixels in a same column arranged along the second direction DR2 among the pixels PX. The second signal line SGL2 is explained as corresponding to any one of data lines connected to the pixels PX.

Some of the pixels connected to the second signal line SGL2 are located above the module hole MH, and other pixels are located below the module hole MH. Accordingly, the pixels in the same column, which are connected to the second signal line SGL2, may receive data signals through a same line, although some pixels centered around the module hole MH may be omitted.

At the point at which the first signal line SGL1 and the second signal line SGL2 cross each other, at least any one of the first signal line SGL1 or the second signal line SGL2 may be disconnected within the first region A1. A connection pattern, which is located on a layer different from that of the disconnected signal line, and which connects the disconnected portion, may be further included. However, the connection relationship between the pixels PX spaced apart from each other with the module hole MH interposed therebetween is not limited thereto.

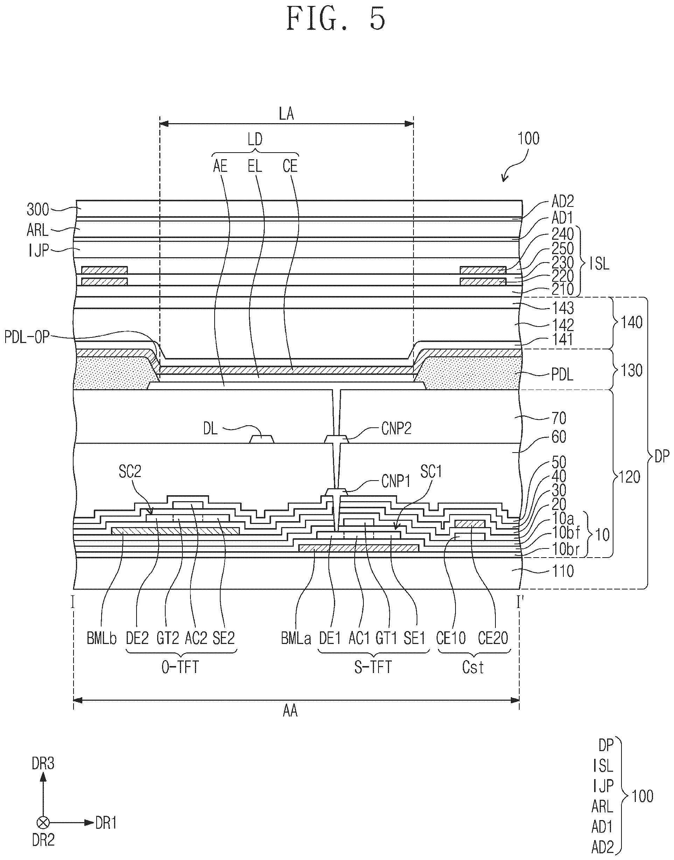

FIG. 5 is a cross-sectional view taken along the line I-I' of FIG. 2. In FIG. 5, the housing 200 described in FIG. 1 is omitted. FIG. 5 illustrates a cross section of the electronic device 1000 corresponding to the pixel PX described in FIG. 2.

Referring to FIG. 5, the electronic device 1000 according to one or more embodiments of the present disclosure may include a display module 100, a housing 200 described in FIG. 2, and a window 300. The display module 100 may include a display panel DP, an input sensor ISL, an organic cover layer IJP, and an anti-reflection layer ARL. The display panel DP may include a base layer 110, a driving element layer 120, a light-emitting element layer 130, and an encapsulation layer 140.

The pixel PX described in FIG. 2 may include a light-emitting element LD and a pixel-driving circuit. The pixel-driving circuit may include a plurality of transistors and a capacitor Cst. FIG. 5 illustrates a silicon transistor S-TFT and an oxide transistor O-TFT. However, the configuration of the pixel-driving circuit is not necessarily limited thereto. The pixel-driving circuit may include only one type of transistor among a silicon transistor S-TFT and an oxide transistor O-TFT.

The base layer 110 may be provided as a single layer. The base layer 110 may be flexible or rigid. For example, the base layer 110 may include a synthetic resin film or any one of glass and metal.

A barrier layer 10br may be located on the base layer 110 (as used herein, "on" may mean "above" or "over"). The barrier layer 10br reduces or prevents foreign substances from entering from the outside. The barrier layer 10br may include at least one inorganic layer. The barrier layer 10br may include a silicon oxide layer and a silicon nitride layer. Each of these may be provided in plurality, and the silicon oxide layers and the silicon nitride layers may be alternately stacked.

A first shielding electrode BMLa may be located on the barrier layer 10br. The first shielding electrode BMLa may correspond to the silicon transistor S-TFT. The first shielding electrode BMLa may include a metal.

The first shielding electrode BMLa may receive a bias voltage. The first shielding electrode BMLa may receive a first power voltage. The first shielding electrode BMLa may block an electric potential caused by polarization from affecting the silicon transistor S-TFT. The first shielding electrode BMLa may block external light from reaching the silicon transistor S-TFT. In one or more embodiments of the present disclosure, the first shielding electrode BMLa may be a floating electrode having a shape isolated from other electrodes or lines.

A buffer layer 10bf may cover the first shielding electrode BMLa, and may be located on the barrier layer 10br. The buffer layer 10bf may reduce or prevent diffusion of metal atoms or impurities from the base layer 110 to a first semiconductor pattern SC1 located thereabove. The buffer layer 10bf may include at least one inorganic layer. The buffer layer 10bf may include a silicon oxide layer and a silicon nitride layer.

The first semiconductor pattern SC1 may be located on the buffer layer 10bf. The first semiconductor pattern SC1 may include a silicon semiconductor. For example, the silicon semiconductor may include amorphous silicon, polycrystalline silicon, and the like. For example, the first semiconductor pattern SC1 may include low-temperature polysilicon.

The first semiconductor pattern SC1 may have different electrical properties depending on whether it is doped or not. The first semiconductor pattern SC1 may include a first region having high conductivity, and a second region having low conductivity. The first region may be doped with an N-type dopant or a P-type dopant. A P-type transistor may include a doped region doped with a P-type dopant, and an N-type transistor may include a doped region doped with an N-type dopant. The second region may be a non-doped region, or may be a region doped with a lower concentration than the first region. The first semiconductor pattern SC1 may be an N-type transistor.

The conductivity of the first region may be greater than that of the second region, and the first region may substantially serve as an electrode or a signal line. The second region may substantially correspond to a channel region (or active region) of a transistor. In other words, a portion of the first semiconductor pattern SC1 may be a channel of a transistor, another portion may be a source or drain of a transistor, and still another portion may be a connection electrode or a connection signal line.

A source region SE1, a channel region AC1 (or active region), and a drain region DE1 of the silicon transistor S-TFT may be formed from the first semiconductor pattern SC1. The source region SE1 and the drain region DE1 may extend in opposite directions from the channel region AC1 on a cross section.

An inorganic insulating layer 10a may cover the first semiconductor pattern SC1, and may be located on the buffer layer 10bf. The inorganic insulating layer 10a may be an inorganic layer. The inorganic insulating layer 10a may be a single-layered silicon oxide layer. An inorganic layer of the driving element layer 120, which will be described later, as well as the inorganic insulating layer 10a may have a single-layered or multi-layered structure, and may include at least one of the above-described materials, but embodiments of the present disclosure are not limited thereto.

For the convenience of explanation, in this specification, the barrier layer 10br, the buffer layer 10bf, and the inorganic insulating layer 10a may be defined as one "first insulating layer 10."

A gate GT1 may be located on the inorganic insulating layer 10a. The gate GT1 overlaps the channel region AC1. The gate GT1 may be a portion of a metal pattern. In a process of doping the first semiconductor pattern SC1, the gate GT1 may be a mask.

A first electrode CE10 of the capacitor Cst may be located on the inorganic insulating layer 10a. According to one or more embodiments of the present disclosure, the first electrode CE10 may have an integral shape with the gate GT1.

A second insulating layer 20 may cover the gate GT1, and may be located on the inorganic insulating layer 10a. In one or more embodiments of the present disclosure, an upper electrode overlapping the gate GT1 may be further located on the second insulating layer 20.

A second electrode CE20 of the capacitor Cst may be located on the second insulating layer 20. The second electrode CE20 may overlap the first electrode CE10. According to one or more embodiments of the present disclosure, the upper electrode overlapping the gate GT1 may have an integral shape with the second electrode CE20 on a plane.

A second shielding electrode BMLb may be located on the second insulating layer 20. The second shielding electrode BMLb may correspond to the oxide transistor O-TFT. In one or more embodiments of the present disclosure, the second shielding electrode BMLb may be omitted. According to one or more embodiments of the present disclosure, the first shielding electrode BMLa may extend below the oxide transistor O-TFT, and may replace the second shielding electrode BMLb.

A third insulating layer 30 may be located on the second insulating layer 20. A second semiconductor pattern SC2 may be located on the third insulating layer 30. The second semiconductor pattern SC2 may include a channel region AC2 of the oxide transistor O-TFT. The second semiconductor pattern SC2 may include an oxide semiconductor. The second semiconductor pattern SC2 may include transparent conductive oxide (TCO) such as indium tin oxide (ITO), indium zinc oxide (IZO), indium gallium zinc oxide (IGZO), zinc oxide (ZnOx), or indium oxide (In2O3).

The oxide semiconductor may include a plurality of regions SE2, AC2, and DE2 divided depending on whether or not the transparent conductive oxide has been reduced. A region (hereinafter referred to as a reduced region), in which the transparent conductive oxide is reduced, has greater conductivity than a region (hereinafter referred to as a non-reduced region) in which the transparent conductive oxide is not reduced. The reduced region substantially serves as a source/drain or signal line of a transistor. The non-reduced region substantially corresponds to a semiconductor region (or channel) of a transistor. In other words, a partial region of the second semiconductor pattern SC2 may be a semiconductor region of a transistor, another partial region thereof may be a source region SE2/drain region DE2 of a transistor, and still another partial region thereof may be a signal transmission region.

A fourth insulating layer 40 may cover the second semiconductor pattern SC2, and may be located on the third insulating layer 30. In one or more embodiments of the present disclosure, the fourth insulating layer 40 may be an insulating pattern that overlaps a gate GT2 of the oxide transistor O-TFT, and that exposes the source region SE2 and the drain region DE2 of the oxide transistor O-TFT.

The gate GT2 of the oxide transistor O-TFT may be located on the fourth insulating layer 40. The gate GT2 of the oxide transistor O-TFT may be a portion of a metal pattern. The gate GT2 of the oxide transistor O-TFT overlaps the channel region AC2.

The fifth insulating layer 50 may cover the gate GT2, and may be located on the fourth insulating layer 40. Each of the inorganic insulating layer 10a and the second insulating layer 20 to the fifth insulating layer 50 may be an inorganic layer. In this specification, the third to fifth insulating layers 30, 40, and 50 may be defined as "middle insulating layers."

A first connection electrode CNP1 may be located on the fifth insulating layer 50. The first connection electrode CNP1 may be connected to the drain region DE1 of the silicon transistor S-TFT through a contact hole passing through the inorganic insulating layer 10a and the second to fifth insulating layers 20, 30, 40, and 50.

A sixth insulating layer 60 (lower interlayer insulating layer) may be located on the fifth insulating layer 50. A second connection electrode CNP2 may be located on the sixth insulating layer 60. The second connection electrode CNP2 may be connected to the first connection electrode CNP1 through a contact hole passing through the sixth insulating layer 60. A data line DL may be located on the sixth insulating layer 60. The second connection electrode CNP2 and the data line DL may include a same material.

A seventh insulating layer 70 (upper interlayer insulating layer) may cover the second connection electrode CNP2 and the data line DL, and may be located on the sixth insulating layer 60. Because the second connection electrode CNP2 and the data line DL may be formed through a same process, they may have a same material and a same stacked structure. In this specification, components located on a same layer and including a same material may be described as being formed through a same process. Each of the sixth insulating layer 60 and the seventh insulating layer 70 may be an organic layer.

The first shielding electrode BMLa, the gate GT1 of the silicon transistor S-TFT, the second electrode CE20, and the gate GT2 of the oxide transistor O-TFT may include molybdenum (Mo), an alloy containing molybdenum, titanium (Ti), or an alloy containing titanium, which has relatively good heat resistance. According to one or more embodiments of the present disclosure, the first connection electrode CNP1 and the second connection electrode CNP2 may include aluminum, which has high electrical conductivity. The first connection electrode CNP1 and the second connection electrode CNP2 may have a three-layer stacked structure of titanium/alum inum/titanium.

The light-emitting element LD may include an anode AE (or first electrode), a common layer EL, and a cathode CE (or second electrode). The anode AE of the light-emitting element LD may be located on the seventh insulating layer 70. The anode AE may be a (semi)transmissive electrode or a reflective electrode. The anode AE may include a stacked structure of ITO/Ag/ITO which are sequentially stacked. The positions of the anode AE and the cathode CE may be changed with each other.

A pixel-defining film PDL may be located on the seventh insulating layer 70. The pixel-defining film PDL may be an organic layer. The pixel-defining film PDL may have a property of absorbing light. For example, the pixel-defining film PDL may have a black color. The pixel-defining film PDL may include a black coloring agent. The black coloring agent may include a black dye and a black pigment. The black coloring agent may include carbon black, a metal such as chromium, or an oxide thereof. The pixel-defining film PDL may correspond to a light-blocking pattern having a property of blocking light.

An opening PDL-OP exposing a portion of the anode AE may be defined in the pixel-defining film PDL. A light-emitting region LA may be defined to correspond to the opening PDL-OP. In one or more embodiments of the present disclosure, the common layer EL may include a light-emitting layer, a hole control layer located between the light-emitting layer and the anode AE, and an electron control layer located between the light-emitting layer and the cathode CE. The hole control layer may include a hole transport layer and may further include a hole injection layer. The electron control layer may include an electron transport layer and may further include an electron injection layer.

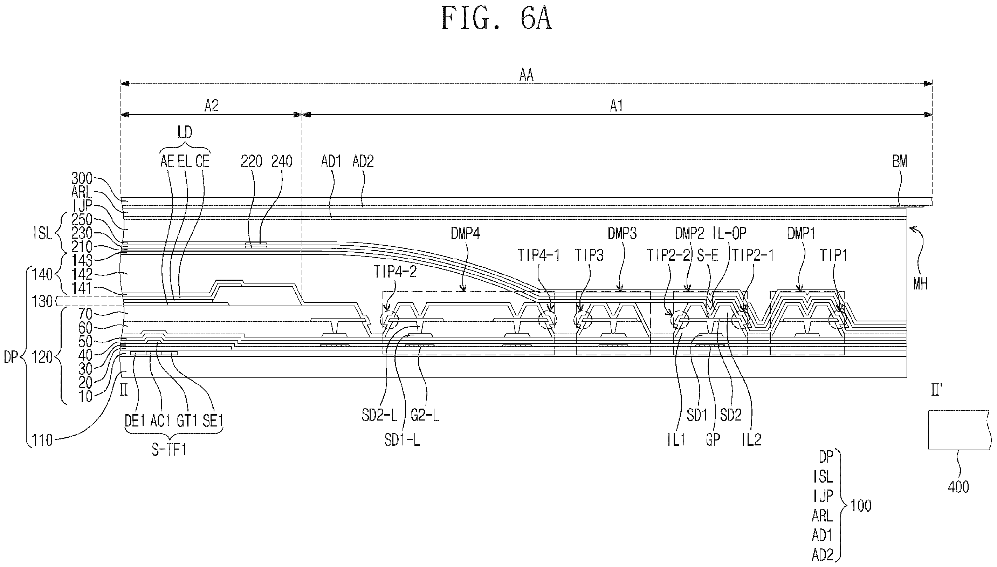

FIG. 6A illustrates that the common layer EL is located and patterned in an opening PDL-OP defined in the pixel-defining film PDL, but this may correspond to the shape of the light-emitting layer included in the common layer EL, and the hole control layer and the electron control layer included in the common layer EL may be formed in an entirety of the first region A1 and the second region A2 through an open mask. If the hole control layer and the electron control layer included in the common layer EL are formed in the entire region, a path through which moisture and oxygen enter the common layer EL through the module hole MH may be provided. Therefore, a structure that disconnects the common layer EL is suitable.

The encapsulation layer 140 may cover the light-emitting element LD. The encapsulation layer 140 may include a first inorganic encapsulation layer 141, an organic encapsulation layer 142, and a second inorganic encapsulation layer 143 that are sequentially stacked, but layers constituting the encapsulation layer 140 are not necessarily limited thereto. The inorganic encapsulation layers 141 and 143 may include a silicon nitride layer, a silicon oxynitride layer, a silicon oxide layer, a titanium oxide layer, an aluminum oxide layer, or the like. Each of the inorganic encapsulation layers 141 and 143 may have a multi-layered structure. The organic encapsulation layer 142 may include an acrylic-based organic layer, but embodiments are not limited thereto. The organic encapsulation layer 142 may have a boundary defined by any one of the dam patterns DMP (or dam patterns DMP1, DMP2, DMP3, and DMP4 of FIG. 6A) in the first region A1. For example, referring to FIG. 6A, the organic encapsulation layer 142 may have a boundary defined by a fourth dam pattern DMP4 in the first region A1.

The input sensor ISL may include at least one conductive layer (or at least one sensor conductive layer) and at least one insulating layer (or at least one sensor insulating layer).

The input sensor ISL may include a first insulating layer 210 (or a first sensor insulating layer), a first conductive layer 220, a second insulating layer 230 (or a second sensor insulating layer), a second conductive layer 240, and a third insulating layer 250 (or a third sensor insulating layer). FIG. 5 illustrates a conductive line of the first conductive layer 220, and a conductive line of the second conductive layer 240.

The first insulating layer 210 may be directly located on the display panel DP. The first insulating layer 210 may be an inorganic layer containing at least one of silicon nitride, silicon oxynitride, or silicon oxide.

Each of the first conductive layer 220 and the second conductive layer 240 may have a single-layered structure, or a multi-layered structure stacked along the third direction DR3. The first conductive layer 220 and the second conductive layer 240 may include conductive lines defining mesh-shaped electrodes. The conductive line of the first conductive layer 220 and the conductive line of the second conductive layer 240 may or may not be connected through a contact hole passing through the second insulating layer 230. The connection relationship between the conductive line of the first conductive layer 220 and the conductive line of the second conductive layer 240 may be determined depending on a type of sensor forming the input sensor ISL.

The first conductive layer 220 and the second conductive layer 240 having a single-layered structure may include a metal layer or a transparent conductive layer. The metal layer may include molybdenum, silver, titanium, copper, aluminum, or an alloy thereof. The transparent conductive layer may include transparent conductive oxide such as indium tin oxide (ITO), indium zinc oxide (IZO), zinc oxide (ZnOx), or indium zinc tin oxide (IZTO). In addition, the transparent conductive layer may include a conductive polymer such as PEDOT, metal nanowire, graphene, and the like.

The first conductive layer 220 and the second conductive layer 240 having a multi-layered structure may include metal layers. The metal layers may have, for example, a three-layer structure of titanium/aluminum/titanium. A multi-layered conductive layer may include at least one metal layer, and at least one transparent conductive layer.

The second insulating layer 230 may be located between the first conductive layer 220 and the second conductive layer 240. The third insulating layer 250 may cover the second conductive layer 240. In one or more embodiments of the present disclosure, the third insulating layer 250 may be omitted. The second insulating layer 230 and the third insulating layer 250 may include an inorganic layer or an organic layer.

An organic cover layer IJP may be located on the input sensor ISL. The organic cover layer IJP may compensate for a step difference generated during a process of forming the display panel DP and the input sensor ISL. Accordingly, a substantially flat surface may be provided to components located on the display panel DP. The organic cover layer IJP may include an organic material. The organic cover layer IJP may be formed on the first adhesive layer AD1 by an inkjet process.

The display module 100 according to one or more embodiments of the present disclosure may further include an anti-reflection layer ARL. The anti-reflection layer ARL may be located between the organic cover layer IJP and the window 300. The anti-reflection layer ARL may reduce reflection of light incident from the outside of the electronic device 1000. That is, the anti-reflection layer ARL may reduce the external light reflectance of the electronic device 1000. The anti-reflection layer ARL according to one or more embodiments of the present disclosure may include a polarizing layer, a phasor, a destructive interference structure, or a plurality of color filters.

A first adhesive layer AD1 may be located between the anti-reflection layer ARL and the organic cover layer IJP to couple the anti-reflection layer ARL and the organic cover layer IJP to each other. The first adhesive layer AD1 may include at least one of an optically clear adhesive, an optically clear adhesive resin, or a pressure sensitive adhesive (PSA).

The window 300 may be located on the anti-reflection layer ARL. A second adhesive layer AD2 may be located between the anti-reflection layer ARL and the window 300 to couple the anti-reflection layer ARL and the window 300 to each other. The second adhesive layer AD2 may include the same material as the first adhesive layer AD1.

FIG. 6A is a cross-sectional view taken along the line II-II' of FIG. 2. FIG. 6B is an enlarged view of one dam pattern illustrated in FIG. 6A.

Referring to FIG. 6A, the active region AA of the electronic device 1000 may include a first region A1 and a second region A2. At least a portion of the first region A1 may overlap the electronic module 400, and the second region A2 may surround at least a portion of the first region A1. The second region A2 may be a region in which the pixels PX described in FIG. 2 are located.

The module hole MH may be formed by passing through the display panel DP, the input sensor ISL, and the organic cover layer IJP. The first adhesive layer AD1, the anti-reflection layer ARL, the second adhesive layer AD2, and the window 300 cover the module hole MH so as to be able to reduce prevent exposure of the sides of the display panel DP, the input sensor, and the organic cover layer IJP, which define the module hole MH. According to one or more embodiments of the present disclosure, a resin layer located inside the module hole MH may be further included.

The first region A1 of the display module 100 may include at least one of dam patterns DMP1, DMP2, DMP3, and DMP4. In FIG. 6B, an enlarged view of a second dam pattern DMP2 is illustrated as an example, and the description of the second dam pattern DMP2 may be applied to first, third, and fourth dam patterns DMP1, DMP3, and DMP4.

Referring to FIG. 6B, each of the dam patterns DMP1, DMP2, DMP3, and DMP4 may include a first pattern SD1, a second pattern SD2, a lower layer IL1, and an upper layer IL2. The fourth dam pattern DMP4 may include first patterns SD1 and second patterns SD2 spaced apart from each other between one lower layer IL1 and one upper layer IL2.

The first pattern SD1 may be located on the fifth insulating layer 50. The first pattern SD1 may be located on the same layer as the first connection electrode CNP1 described in FIG. 5. The first pattern SD1 may be formed through the same process as the first connection electrode CNP1. Accordingly, the first pattern SD1 may include the same material as the first connection electrode CNP1.

The lower layer IL1 may cover the first pattern SD1, and may be located on the fifth insulating layer 50. The lower layer IL1 may include, or define, a contact hole I-C exposing at least a portion of the first pattern SD1. Substantially, the lower layer IL1 may be formed by applying a material forming the sixth insulating layer 60 to the entire surface of the active region AA, and by performing patterning so as to overlap the first patterns SD1. Accordingly, the lower layer IL1 may include the same material as the sixth insulating layer 60. The lower layer IL1 and the sixth insulating layer 60 may include an organic material.

The second pattern SD2 may be located on the lower layer IL1. The second pattern SD2 may be located in the contact hole I-C defined in the lower layer IL1, and may contact the first pattern SD1 exposed from the contact hole I-C. The second pattern SD2 may include the same material as that located on the sixth insulating layer 60, which is described in FIG. 5. Accordingly, the second pattern SD2 may include the same material as the data line DL and the second connection electrode CNP2. The second pattern SD2 may have a three-layer stacked structure of titanium/aluminum/titanium.

According to the present disclosure, opposing ends of the second pattern SD2 may protrude to the outside from the lower layer IL1 and the upper layer IL2. Portions protruding from the lower layer IL1 and the upper layer IL2 may be defined as tip portions TIP2-1 and TIP2-2.

The side surface of the lower layer IL1, the tip portions TIP2-1 and TIP2-2 of the second pattern SD2, and the side surface and upper surface of the upper layer IL2 may be covered by the first inorganic encapsulation layer 141.

As the tip portions TIP2-1 and TIP2-2 protrude from the lower layer IL1, the tip portions TIP2-1 and TIP2-2 and the lower layer IL1 may have an undercut shape.

As illustrated in FIG. 6A, the first dam pattern DMP1 may include one tip portion TIP1 protruding in a direction adjacent to the module hole MH, and the third dam pattern DMP3 may include a tip portion TIP3 protruding in a direction toward the fourth dam pattern DMP4. The fourth dam pattern DMP4 may include a first tip portion TIP4-1 protruding from one second pattern SD2, and a second tip portion TIP4-2 protruding from the other second pattern SD2.

Referring again to FIG. 6B, the upper layer IL2 may be located on the second pattern SD2. The upper layer IL2 may overlap the lower layer IL1. Substantially, the upper layer IL2 may be formed by applying a material forming the seventh insulating layer 70 to the entire surface of the active region AA, and by performing patterning so as to overlap the second patterns SD2. Accordingly, the upper layer IL2 may include the same material as the seventh insulating layer 70. The upper layer IL2 and the seventh insulating layer 70 may include an organic material.

The upper layer IL2 according to the present disclosure may include/define an opening IL-OP exposing a portion S-E of the second pattern SD2. As the upper layers IL2 are spaced apart from each other with the opening IL-OP interposed therebetween, an organic layer located on the upper layers IL2, for example, a second floating pattern EL-T may be divided on the upper layers IL2. The second floating pattern EL-T may be defined as an organic material that is formed in the first region A1 in a process of forming the common layer EL, and that is disconnected from the common layer EL located in the second region A2 by the second dam pattern DMP2. Therefore, it is possible to suitably block a path through which moisture and oxygen enter through the floating pattern EL-T located on the upper layer IL2.

The second dam pattern DMP2 according to one or more embodiments of the present disclosure may further include a dummy pattern GP. The dummy pattern GP may overlap the first pattern SD1. The dummy pattern GP may be located on the same layer as the second electrode CE20 of the capacitor Cst described in FIG. 5, and may include the same material as the second electrode CE20. As illustrated in FIG. 6A, the dummy pattern GP may be included in the second to fourth dam patterns DMP2, DMP3, and DMP4, and may be omitted in the first dam pattern DMP1.

According to one or more embodiments of the present disclosure, an additional dummy pattern located between the first insulating layer 10 and the second insulating layer 20 and overlapping the dummy pattern GP may be further included. According to one or more embodiments of the present disclosure, an additional dummy pattern may include a same material as the gate GT1 or the first semiconductor pattern SC1 of the silicon transistor S-TFT as illustrated in FIG. 5.

The window 300 according to one or more embodiments of the present disclosure may further include a bezel pattern BM located on the rear surface of the window 300. The bezel pattern BM may be printed or colored on the rear surface of the window 300, or may be attached thereto by a separate adhesive layer.

An opening located in the first region A1 and overlapping the module hole MH may be defined in the bezel pattern BM. The bezel pattern BM may block unnecessary external light from entering the electronic module 400, thereby improving the performance of the electronic module 400. In addition, the bezel pattern BM may reduce or prevent a user's visual recognition of components located in the first region A1. The bezel pattern BM may include a material that blocks light, but embodiments of the present disclosure are not limited.

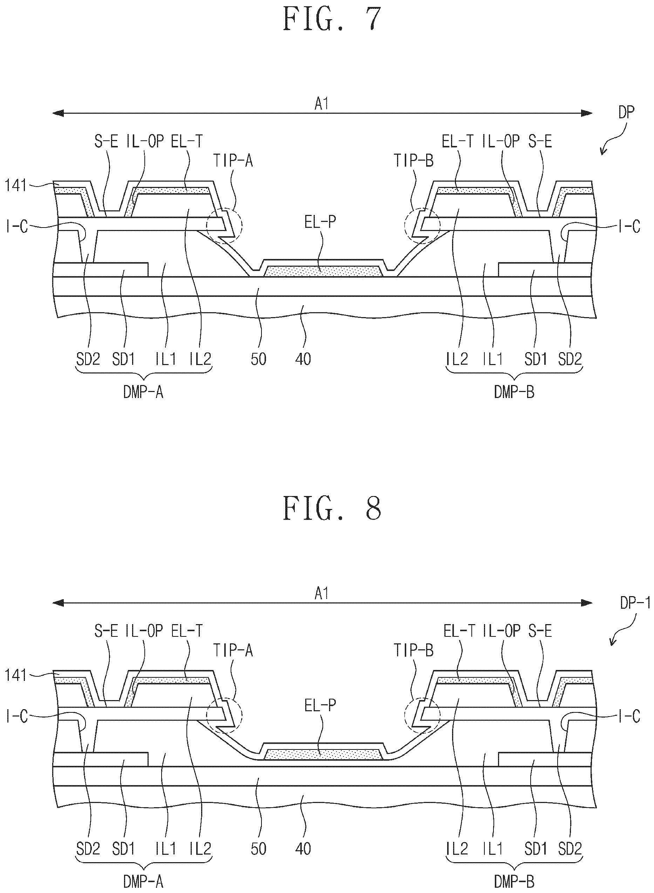

FIGS. 7 to 14 are cross-sectional views illustrating a portion of the first region of the display module according to one or more embodiments of the present disclosure. Descriptions of dam patterns DMP-A and DMP-B illustrated in FIGS. 7 to 14 may be applied to the dam patterns DMP1, DMP2, DMP3, and DMP4 illustrated in FIG. 6A. The same/similar reference numerals are used for the same/similar components as those described in FIGS. 1 to 6B, and duplicate descriptions are omitted.

Referring to FIG. 7, the display panel DP according to one or more embodiments of the present disclosure may include a first dam pattern DMP-A and a second dam pattern DMP-B located in the first region A1 and spaced apart from each other. Each of the first dam pattern DMP-A and the second dam pattern DMP-B may include a first pattern SD1, a second pattern SD2, a lower layer IL1, and an upper layer IL2.

The first pattern SD1 may be located on the fifth insulating layer 50. The lower layer IL1 may cover the first pattern SD1, and may be located on the fifth insulating layer 50. The lower layer IL1 may include/define a contact hole I-C exposing at least a portion of the first pattern SD1. The lower layer IL1 may include an organic material.

The second pattern SD2 may be located on the lower layer IL1. The second pattern SD2 may be located in the contact hole I-C defined in the lower layer IL1, and may contact the first pattern SD1 exposed through the contact hole I-C.

The upper layer IL2 may cover the second pattern SD2, and may be located above the lower layer IL1. The upper layer IL2 according to the present disclosure may include/define an opening IL-OP exposing at least a portion S-E of the second pattern SD2. As the upper layer IL2 includes/defines the opening IL-OP, the length of the second floating pattern EL-T located on the upper layer IL2 may be increased, or the second floating pattern EL-T may be divided. The second floating pattern EL-T may be disconnected from the common layer EL described in FIG. 5.

A portion of the second pattern SD2 of the first dam pattern DMP-A may protrude in a direction toward the second dam pattern DMP-B from the lower layer IL1 and the upper layer IL2. The protruding portion may be defined as a first tip portion TIP-A.

A portion of the second pattern SD2 of the second dam pattern DMP-B may protrude in a direction toward the first dam pattern DMP-A from the lower layer IL1 and the upper layer IL2. The protruding portion may be defined as a second tip portion TIP-B.

According to the present disclosure, the first dam pattern DMP-A and the second dam pattern DMP-B may be spaced apart from each other to expose a portion of the fifth insulating layer 50. A first floating pattern EL-P may be located on the fifth insulating layer 50 exposed by the first dam pattern DMP-A and the second dam pattern DMP-B. The first floating pattern EL-P may be defined as an organic material that is formed in the first region A1 in a process of forming the common layer EL and that is disconnected from the common layer EL (see FIG. 6A) located in the second region A2 by the first dam pattern DMP-A and the second dam pattern DMP-B. Accordingly, the first floating pattern EL-P may include the same material as the common layer EL.

If the common layer EL (see FIG. 6A) is formed in the first region A1, the common layer EL (see FIG. 6A) formed between the first dam pattern DMP-A and the second dam pattern DMP-B may be suitably divided by the tip portions TIP-A and TIP-B in a region between the first dam pattern DMP-A and the second dam pattern DMP-B.

In addition, the upper layer IL2 according to the present disclosure may include/define an opening IL-OP exposing a portion S-E of the second pattern SD2. As the upper layers IL2 are spaced apart from each other with the opening IL-OP interposed therebetween, the second floating pattern EL-T located on the upper layer IL2 may be divided on the upper layers IL2. The second floating pattern EL-T may be defined as an organic material that is formed in the first region A1 in a process of forming the common layer EL, and that is disconnected from the common layer EL located in the second region A2 by the opening IL-OP. Accordingly, the second floating pattern EL-T and the common layer EL may include a same material.

According to one or more embodiments of the present disclosure, the dam patterns DMP-A and DMP-B, the floating patterns EL-P and EL-T, and a portion of the fifth insulating layer 50 exposed by the dam patterns DMP-A and DMP-B, may be covered by the first inorganic encapsulation layer 141.

According to the present disclosure, the common layer EL (see FIG. 6A) is primarily divided by the tip portions TIP-A and TIP-B in a region between the dam patterns DMP-A and DMP-B, and as the upper layer IL2 included in each of the dam patterns DMP-A and DMP-B includes an opening IL-OP, the common layer EL (see FIG. 6A) may be secondarily divided by the opening IL-OP. According to one or more embodiments of the present disclosure, although the common layer EL (see FIG. 6A) is not divided by the opening IL-OP, as the length of the common layer EL (see FIG. 6A) located on the side defining the opening IL-OP increases, a path through which moisture and oxygen enter the common layer EL (see FIG. 6A) in the second region A2 from the module hole MH becomes longer, thus making it possible to delay the inflow of moisture and oxygen. Therefore, it is possible to suitably block/delay moisture and oxygen which flow into the module hole MH. Accordingly, the electronic device 1000 (see FIG. 1) with improved display quality and improved performance of the electronic module may be provided.

Referring to FIG. 8, a display panel DP-1 according to one or more embodiments of the present disclosure may include a first dam pattern DMP-A and a second dam pattern DMP-B located in the first region A1 and spaced apart from each other. Each of the first dam pattern DMP-A and the second dam pattern DMP-B may include a first pattern SD1, a second pattern SD2, a lower layer IL1, and an upper layer IL2.

The first pattern SD1 may be located on the fifth insulating layer 50. The lower layer IL1 may cover the first pattern SD1, and may be located on the fifth insulating layer 50. The lower layer IL1 may include/define a contact hole I-C exposing at least a portion of the first pattern SD1. The second pattern SD2 may be located on the lower layer IL1. The second pattern SD2 may be located in the contact hole I-C defined in the lower layer IL1, and may contact the first pattern SD1 exposed through the contact hole I-C.

The upper layer IL2 may cover the second pattern SD2, and may be located above the lower layer IL1. The upper layer IL2 according to the present disclosure may include/define an opening IL-OP exposing at least a portion S-E of the second pattern SD2. As the upper layer IL2 includes/defines the opening IL-OP, the length of the second floating pattern EL-T located on the upper layer IL2 may be increased, or the second floating pattern EL-T may be divided.

The lower layer IL1 included in the first dam pattern DMP-A and the lower layer IL1 included in the second dam pattern DMP-B may be connected to each other. Accordingly, the first floating pattern EL-P may be located on the lower layers IL1 connected to each other. The first floating pattern EL-P may include the same material as the common layer EL (see FIG. 6A).

The upper layer IL2 may include/define an opening IL-OP exposing a portion S-E of the second pattern SD2. As the upper layers IL2 are spaced apart from each other with the opening IL-OP interposed therebetween, the second floating pattern EL-T located on the upper layer IL2 may be divided on the upper layers IL2. The second floating pattern EL-T may include the same material as the common layer EL (see FIG. 6A).

According to one or more embodiments of the present disclosure, the dam patterns DMP-A and DMP-B, the floating patterns EL-P and EL-T, and the lower layers IL1 connected to each other may be covered by the first inorganic encapsulation layer 141.

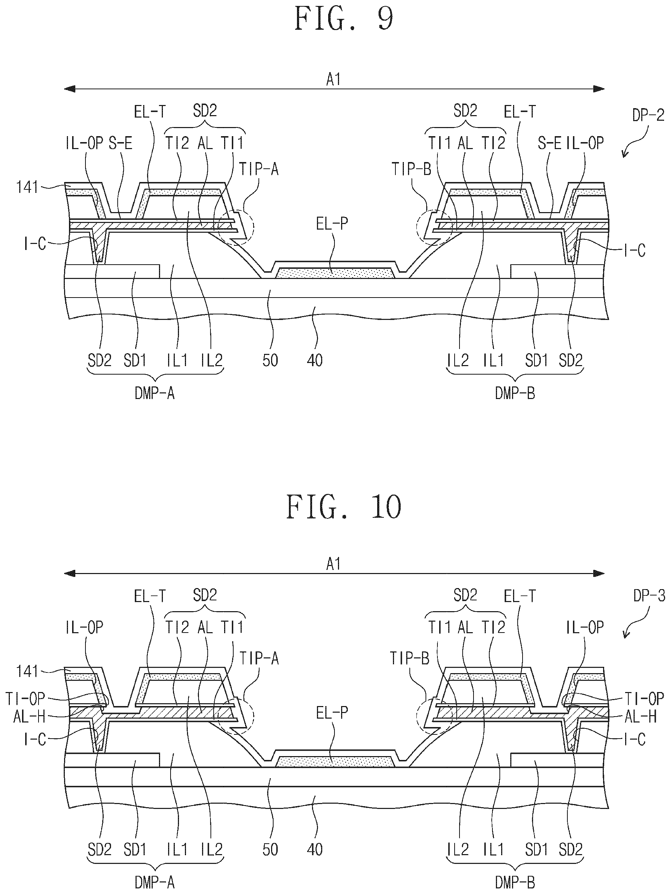

Referring to FIG. 9, a display panel DP-2 according to one or more embodiments of the present disclosure may include a first dam pattern DMP-A and a second dam pattern DMP-B located in the first region A1 and spaced apart from each other. Each of the first dam pattern DMP-A and the second dam pattern DMP-B may include a first pattern SD1, a second pattern SD2, a lower layer IL1, and an upper layer IL2.

The first pattern SD1 may be located on the fifth insulating layer 50. The lower layer IL1 may cover the first pattern SD1, and may be located on the fifth insulating layer 50. The lower layer IL1 may include/define a contact hole I-C exposing at least a portion of the first pattern SD1. The second pattern SD2 may be located on the lower layer IL1. The second pattern SD2 may be located in the contact hole I-C defined in the lower layer IL1, and may contact the first pattern SD1 exposed through the contact hole I-C.

The upper layer IL2 may cover the second pattern SD2, and may be located above the lower layer IL1. The upper layer IL2 according to the present disclosure may include/define an opening IL-OP exposing at least a portion S-E of the second pattern SD2. As the upper layer IL2 includes/defines the opening IL-OP, the length of the second floating pattern EL-T located on the upper layer IL2 may be increased, or the second floating pattern EL-T may be divided.

The descriptions of the first dam pattern DMP-A and the second dam pattern DMP-B are the same as those described in FIG. 7, and differences will be mainly described.

The second pattern SD2 included in each of the first dam pattern DMP-A and the second dam pattern DMP-B may include a plurality of conductive layers. According to one or more embodiments of the present disclosure, the second pattern SD2 may include a first layer TI1, a second layer AL, and a third layer TI2, which are sequentially stacked. The thicknesses of the first layer TI1 and the third layer TI2 may be less than the thickness of the second layer AL. The first layer TI1 and the third layer TI2 may include titanium (Ti), and the second layer AL may include aluminum (Al). Like the second pattern SD2, the data line DL described with reference to FIG. 5 may also include a first layer TI1, a second layer AL, and a third layer TI2, which are sequentially stacked.

According to one or more embodiments of the present disclosure, among the layers of second pattern SD2, the first layer TI1 and the third layer TI2 located in portions defined as the tip portions TIP-A and TIP-B may protrude relatively more in a direction toward an adjacent dam pattern than the second layer AL. Among the second pattern SD2, the shapes of the tip portions TIP-A and TIP-B may be formed due to differences in etch rate between the first to third layers TI1, AL, and TI2.

Accordingly, the common layer EL (see FIG. 6A) may be more suitably divided due to the shapes of the tip portions TIP-A and TIP-B. Accordingly, a movement path through which moisture and oxygen enter the common layer EL (see FIG. 6A) in the second region A2 from the module hole MH (see FIG. 6A) may be suitably blocked.

Referring to FIG. 10, a display panel DP-3 according to one or more embodiments of the present disclosure may include a first dam pattern DMP-A and a second dam pattern DMP-B located in the first region A1 and spaced apart from each other. Each of the first dam pattern DMP-A and the second dam pattern DMP-B may include a first pattern SD1, a second pattern SD2, a lower layer IL1, and an upper layer IL2.

The second pattern SD2 included in each of the first dam pattern DMP-A and the second dam pattern DMP-B may include a plurality of conductive layers. According to one or more embodiments of the present disclosure, the second pattern SD2 may include a first layer TI1, a second layer AL, and a third layer TI2 that are sequentially stacked. The thicknesses of the first layer TI1 and the third layer TI2 may be less than the thickness of the second layer AL. The first layer TI1 and the third layer TI2 may include titanium (Ti), and the second layer AL may include aluminum (Al).

The descriptions of the first dam pattern DMP-A and the second dam pattern DMP-B are the same as those described in FIG. 9, and differences will be mainly described.

The second pattern SD2 included in each of the first dam pattern DMP-A and the second dam pattern DMP-B may further include a hole overlapping the opening IL-OP. The hole may include a groove AL-H, from which a portion of the second layer AL is removed, and a pattern opening TI-OP which passes through the third layer TI2, and that overlaps the groove AL-H. The groove AL-H may expose the lower surface of the third layer TI2 overlapping the groove AL-H.

A process of forming the pattern opening TI-OP by removing the third layer TI2 may use a fluorine-based process gas used in a process of ashing a photoresist layer used as a mask when an insulating layer located on the second pattern SD2 and containing an organic material is patterned. For example, the process gas may contain fluorinated carbon.

The second floating pattern EL-T located on the upper layer IL2 may be divided by the hole defined in the second pattern SD2. Accordingly, as the common layer EL (see FIG. 6A) located in the second region A2 (see FIG. 6A) and the second floating pattern EL-T are divided, it is possible to suitably block the movement path of moisture and oxygen that may enter the module hole MH (see FIG. 6A).

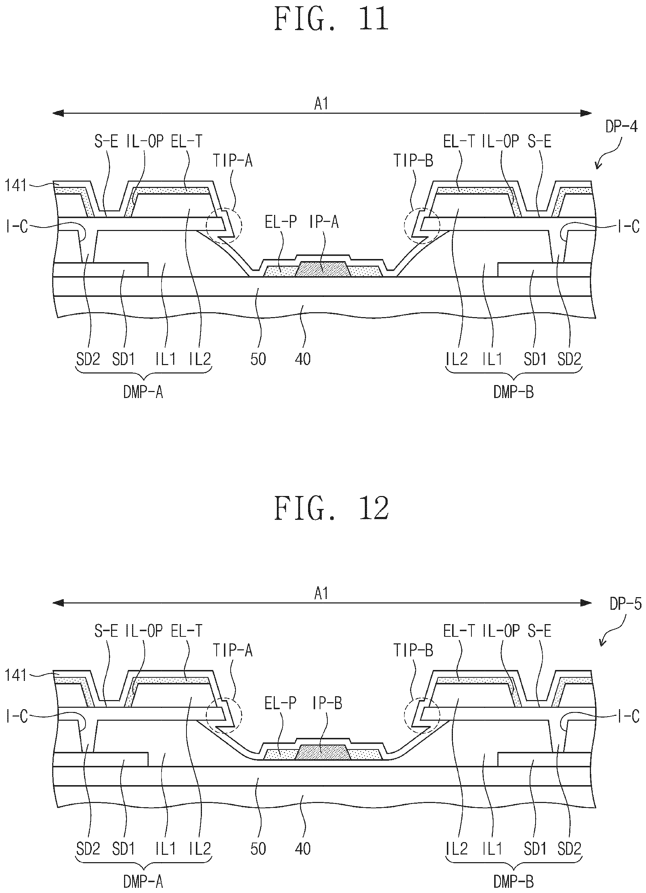

Referring to FIG. 11, a display panel DP-4 according to one or more embodiments of the present disclosure may include a first dam pattern DMP-A and a second dam pattern DMP-B located in the first region A1 and spaced apart from each other. Each of the first dam pattern DMP-A and the second dam pattern DMP-B may include a first pattern SD1, a second pattern SD2, a lower layer IL1, and an upper layer IL2.

The first pattern SD1 may be located on the fifth insulating layer 50. The lower layer IL1 may cover the first pattern SD1, and may be located on the fifth insulating layer 50. The lower layer IL1 may include/define a contact hole I-C exposing at least a portion of the first pattern SD1. The second pattern SD2 may be located on the lower layer IL1. The second pattern SD2 may be located in the contact hole I-C defined in the lower layer IL1, and may contact the first pattern SD1 exposed through the contact hole I-C.

The descriptions of the first dam pattern DMP-A and the second dam pattern DMP-B are the same as those described in FIG. 7, and differences will be mainly described.

The display panel DP-4 according to one or more embodiments of the present disclosure may further include a blocking pattern IP-A. The blocking pattern IP-A may be located between the first dam pattern DMP-A and the second dam pattern DMP-B, which are adjacent to each other. The blocking pattern IP-A may be located on the fifth insulating layer 50 exposed from the first dam pattern DMP-A and the second dam pattern DMP-B. The blocking pattern IP-A may be formed in the same process as the first pattern SD1, and may include the same material as the first pattern SD1. The blocking pattern IP-A may be covered by the first inorganic encapsulation layer 141.

As the blocking pattern IP-A is formed between the first dam pattern DMP-A and the second dam pattern DMP-B, the first floating pattern EL-P, which may be formed after the blocking pattern IP-A is formed, may be divided. Therefore, the movement path of moisture and oxygen enter the common layer EL (see FIG. 6A) in the second region A2 from the module hole MH (see FIG. 6B) may be suitably blocked.

Referring to FIG. 12, a display panel DP-5 according to one or more embodiments of the present disclosure may include a first dam pattern DMP-A and a second dam pattern DMP-B located in the first region A1 and spaced apart from each other. Each of the first dam pattern DMP-A and the second dam pattern DMP-B may include a first pattern SD1, a second pattern SD2, a lower layer IL1, and an upper layer IL2.

The first pattern SD1 may be located on the fifth insulating layer 50. The lower layer IL1 may cover the first pattern SD1, and may be located on the fifth insulating layer 50. The lower layer IL1 may include/define a contact hole I-C exposing at least a portion of the first pattern SD1. The second pattern SD2 may be located on the lower layer IL1. The second pattern SD2 may be located in the contact hole I-C defined in the lower layer IL1, and may contact the first pattern SD1 exposed through the contact hole I-C.

The upper layer IL2 may cover the second pattern SD2, and may be located above the lower layer IL1. The upper layer IL2 according to the present disclosure may include/define an opening IL-OP exposing at least a portion S-E of the second pattern SD2. As the upper layer IL2 includes/defines the opening IL-OP, the length of the second floating pattern EL-T located on the upper layer IL2 may be increased, or the second floating pattern EL-T may be divided.

The lower layer IL1 included in the first dam pattern DMP-A and the lower layer IL1 included in the second dam pattern DMP-B may be connected to each other. Accordingly, the first floating pattern EL-P may be located on the lower layers IL1 connected to each other. The first floating pattern EL-P may include the same material as the common layer EL (see FIG. 6A).

The display panel DP-5 may further include a blocking pattern IP-B. The blocking pattern IP-B may be located between the first dam pattern DMP-A and the second dam pattern DMP-B, which are adjacent to each other. The blocking pattern IP-B may be located on the lower layers IL1 connected to each other. The first floating pattern EL-P may be divided by the blocking pattern IP-B on the lower layers IL1 connected to each other.

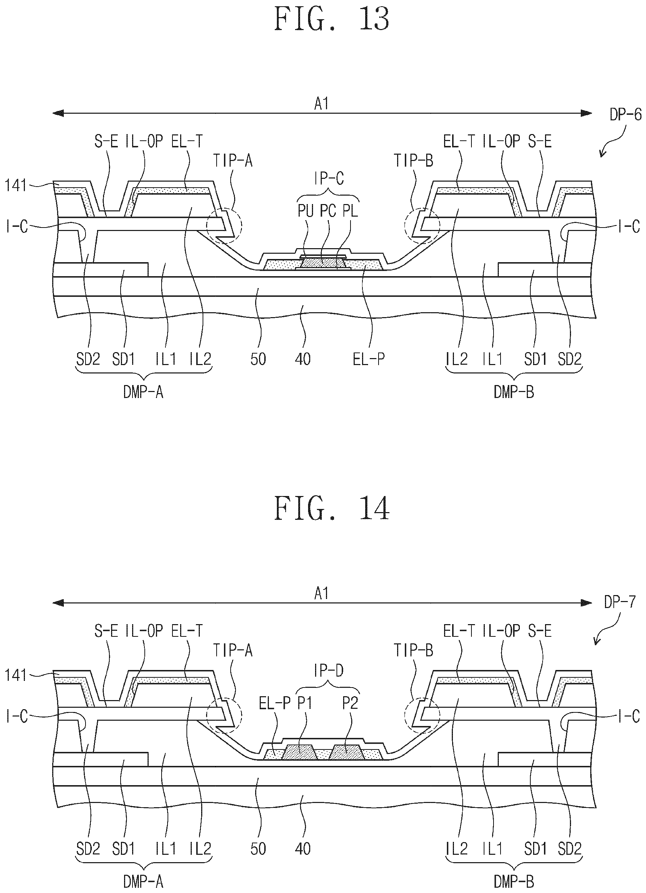

Referring to FIG. 13, a display panel DP-6 according to one or more embodiments of the present disclosure may include a first dam pattern DMP-A and a second dam pattern DMP-B located in the first region A1 and spaced apart from each other. Each of the first dam pattern DMP-A and the second dam pattern DMP-B may include a first pattern SD1, a second pattern SD2, a lower layer IL1, and an upper layer IL2.

The descriptions of the first dam pattern DMP-A and the second dam pattern DMP-B are the same as those of the first dam pattern DMP-A and the second dam pattern DMP-B described in FIG. 12, and differences will be mainly described.

The blocking pattern IP-C may include a plurality of conductive layers. According to one or more embodiments of the present disclosure, the second pattern SD2 may include a first layer PL, a second layer PC, and a third layer PU that are sequentially stacked. The thicknesses of the first layer PL and the third layer PU may be less than the thickness of the second layer PC. The first layer PL and the third layer PU may include titanium (Ti), and the second layer PC may include aluminum (Al).

According to one or more embodiments of the present disclosure, the ends of the first layer PL and the third layer PU may protrude relatively more in a direction toward an adjacent dam pattern than the end of the second layer PC. The shape of the end of the blocking pattern IP-C may be formed due to differences in etch rate between the first to third layers PL, PC, and PU.

Referring to FIG. 14, a display panel DP-7 according to one or more embodiments of the present disclosure may include a first dam pattern DMP-A and a second dam pattern DMP-B located in the first region A1 and spaced apart from each other. Each of the first dam pattern DMP-A and the second dam pattern DMP-B may include a first pattern SD1, a second pattern SD2, a lower layer IL1, and an upper layer IL2.

The descriptions of the first dam pattern DMP-A and the second dam pattern DMP-B are the same as those of the first dam pattern DMP-A and the second dam pattern DMP-B described in FIG. 12, and differences will be mainly described.

The display panel DP-7 may further include a blocking pattern IP-D. The blocking pattern IP-D may include a plurality of patterns P1 and P2 spaced apart from each other. The patterns P1 and P2 may surround the module hole MH (see FIG. 6B) on a plane. The first floating pattern EL-P may be suitably divided by the patterns P1 and P2 on the lower layers IL1 connected to each other.

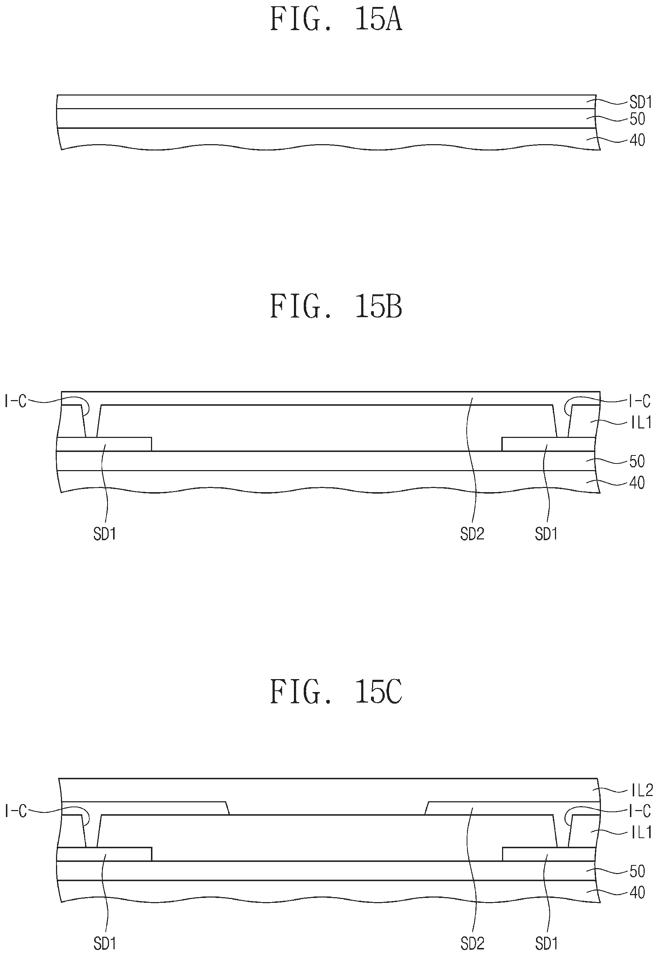

FIGS. 15A to 15H are cross-sectional views illustrating a manufacturing method for forming a dam pattern according to one or more embodiments of the present disclosure. The same/similar reference numerals are used for the same/similar components as those described in FIGS. 1 to 7, and duplicate descriptions are omitted.

Referring to FIG. 15A, a method of manufacturing an electronic device according to one or more embodiments of the present disclosure may include forming a first pattern SD1. The first pattern SD1 may be formed on the fifth insulating layer 50. The first pattern SD1 may be formed through the same process as the first connection electrode CNP1 described in FIG. 5. The first pattern SD1 may be formed by stacking a plurality of conductive layers. For example, the first pattern SD1 may have a three-layer structure in which titanium (Ti), aluminum (Al), and titanium (Ti) are sequentially stacked.

Referring to FIG. 15B, the method of manufacturing the electronic device according to one or more embodiments of the present disclosure may include patterning the first pattern SD1, forming a lower layer IL1 on the first pattern SD1, and forming a second pattern SD2 on the lower layer IL1.

The patterning of the first pattern SD1 may include patterning the first pattern SD1 into a plurality of first patterns SD1 by removing a portion of one first pattern SD1.

The forming of the lower layer IL1 may be performed by applying the same material as the sixth insulating layer 60 described in FIG. 5 on the fifth insulating layer 50. The lower layer IL1 may include an organic material. According to one or more embodiments of the present disclosure, forming a contact hole I-C that passes through the lower layer IL1, and that exposes the first pattern SD1, may be further included.

The forming of the second pattern SD2 may be performed by forming and patterning a conductive material on the lower layer IL1. The second pattern SD2 may be formed through the same process as the second connection electrode CNP2 described in FIG. 5. The second pattern SD2 may be formed by stacking a plurality of conductive layers. For example, the second pattern SD2 may have a three-layer structure in which titanium (Ti), aluminum (Al), and titanium (Ti) are sequentially stacked.

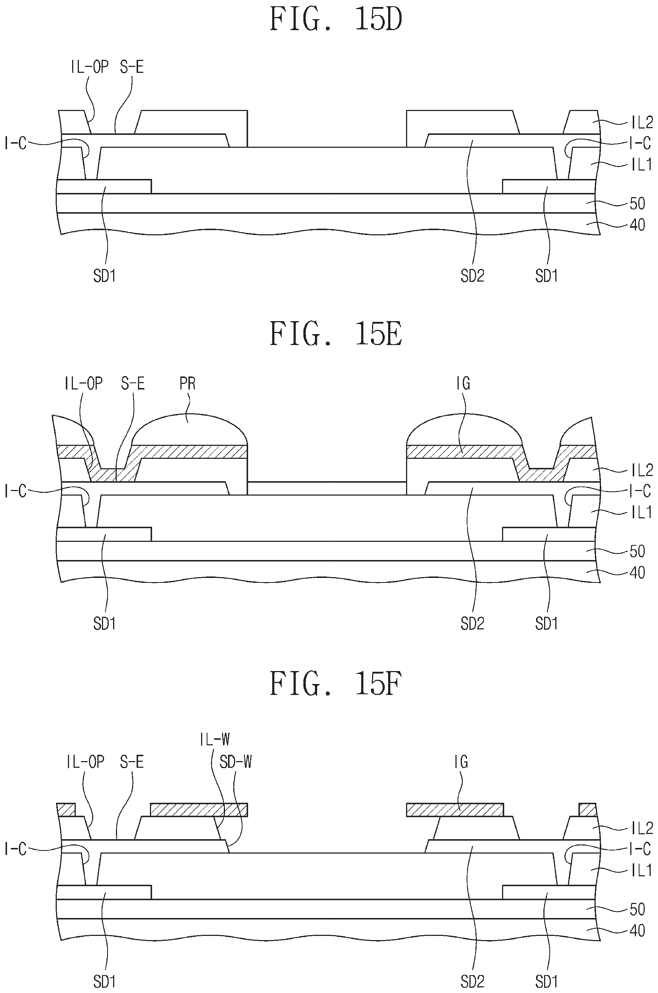

Referring to FIGS. 15C and 15D, the method of manufacturing the electronic device according to one or more embodiments of the present disclosure may include forming an upper layer IL2. The forming of the upper layer IL2 may be performed by applying the same material as the seventh insulating layer 70 described in FIG. 5 on the sixth insulating layer 60. The upper layer IL2 may include an organic material.

The upper layer IL2 may have a thickness reduced by about 30% to about 70%, as compared to the thickness of the lower layer IL1. The upper layer IL2 may be formed with a halftone mask.

Hereafter, patterning the upper layer IL2 may be included. One upper layer IL2 may be partially removed and patterned into upper layers IL2 spaced apart from each other. The lower layer IL1 may be exposed between the upper layers IL2 that are spaced apart from each other.

Forming an opening IL-OP in each of the upper layers IL2 may be included. A portion S-E of the second pattern SD2 may be exposed from the upper layer IL2 through the opening IL-OP.

Referring to FIGS. 15E and 15F, the method of manufacturing the electronic device according to one or more embodiments of the present disclosure may include forming a mask pattern IG and forming a photoresist pattern PR. The mask pattern IG may be entirely located on the lower layer IL1 and the upper layer IL2. According to one or more embodiments of the present disclosure, the mask pattern IG may include Indium Gallium Zinc Oxide (IGZO).

Hereafter, a photoresist pattern PR may be formed on the mask pattern IG overlapping the upper layers IL2. The photoresist pattern PR is not limited to any embodiments if it is used in a photoresist process.

Hereafter, patterning the mask pattern IG by using the photoresist pattern PR as a mask may be included. In this case, the patterning of the mask pattern IG may be performed through a wet etching process. The mask pattern IG may be patterned and located only on the upper layers IL2, and the mask pattern IG initially located on the lower layer IL1 may be removed.

Hereafter, removing the photoresist pattern PR may be included.

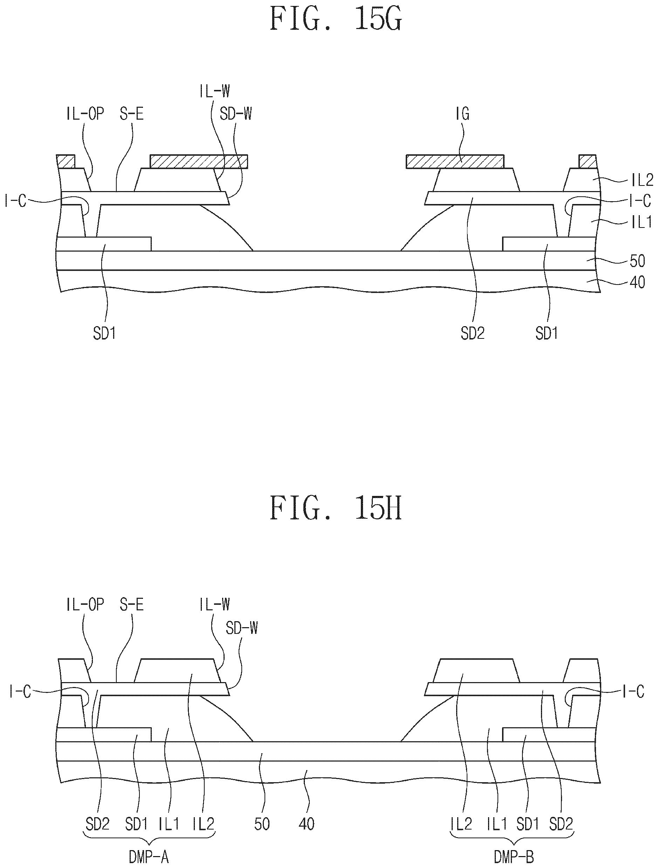

Referring to FIG. 15G, the method of manufacturing the electronic device according to one or more embodiments of the present disclosure may include patterning the lower layer IL1. A portion of the lower layer IL1 may be removed by using the mask pattern IG as a mask. The patterning of the lower layer IL1 may be performed through a dry etching process. In the dry etching process, only oxygen (02) may be used as a process gas.

Referring to FIG. 15H, the method of manufacturing the electronic device according to one or more embodiments of the present disclosure may include removing the mask pattern IG. The mask pattern IG may be removed through a wet etching process.

A first dam pattern DMP-A and a second dam pattern DMP-B spaced apart from each other may be formed on the fifth insulating layer 50. Each of the first dam pattern DMP-A and the second dam pattern DMP-B may include a first pattern SD1, a second pattern SD2, a lower layer IL1, and an upper layer IL2.

A first width defined between sides SD-W of the second patterns SD2 may be less than a second width defined between sides IL-W of the upper layers IL2. Accordingly, the common layer EL (see FIG. 6A) formed between the first dam pattern DMP-A and the second dam pattern DMP-B may be divided by the second patterns SD2 between the first dam pattern DMP-A and the second dam pattern DMP-B.

In addition, as the upper layers IL2 include/define an opening IL-OP, the length of the common layer EL (see FIG. 6A) formed on the upper layers IL2 may be increased, or the common layer EL (see FIG. 6A) may be divided by the opening IL-OP on the upper layers IL2.

As discussed, embodiments may provide an electronic device comprising: a display module including a module hole, and comprising a base layer including a first region surrounded by a second region in plan view, pixels in the second region, data lines connected to the pixels, and dam patterns in the first region and surrounding the module hole in plan view, the dam patterns comprising a first pattern above the base layer, a lower layer above the first pattern, a second pattern above the lower layer and comprising a same material as the data lines, and an upper layer above the second pattern and defining an opening exposing a portion of the second pattern; a window above the display module; and an electronic module below the display module, overlapping the first region, and overlapping the module hole.

The first region may surround the module hole in plan view.

The first region may be circular, or have a polygonal shape or an oval shape in plan view. The module hole may be circular, or have a polygonal shape or an oval shape in plan view, surrounded by the first region.

The dam pattern may have a closed-line shape surrounding the module hole in plan view. The dam pattern may have circular line shape. The dam patterns may be provided as concentric line shapes in plan view.

The first pattern may be formed through a same process as a connection electrode.

The lower layer may be formed of an insulating layer, for example an organic material.

The lower layer may cover the first pattern. The lower layer may include a contact hole exposing at least a portion of the first pattern.

The second pattern may be located on the lower layer. A portion of the second pattern may be located in the contact hole defined in the lower layer, and may contact the first pattern exposed from the contact hole.

The upper layer may be formed of an insulating layer, for example an organic material.

The upper layer may be located on the second pattern. The upper layer may overlap the lower layer.

The upper layer includes an opening exposing a portion of the second pattern. As portions of the upper layers are spaced apart from each other with the opening interposed therebetween, an organic layer located on the upper layers, for example, a floating pattern may be divided on the portions of the upper layers.

A floating pattern may be defined as an organic material that is formed in the first region in a process of forming a common light emitting layer, and that is disconnected from the common light emitting layer located in the second region by the dam pattern.

Embodiments can provide an electronic device comprising: a display module comprising a base layer including a first region and a second region surrounding the first region, dam patterns disposed in the first region, pixels disposed in the second region, and data lines connected to the pixels; a window disposed on the display module; and an electronic module disposed below the display module overlapping the first region, wherein the display module includes a module hole defined through a portion of the display module overlapping the electronic module and surrounded by the dam patterns, wherein each of the dam patterns comprises: a first pattern disposed on the base layer; a lower layer disposed on the first pattern; a second pattern disposed on the lower layer; and an upper layer disposed on the second pattern, wherein: the second pattern includes the same material as the data lines; and the upper layer has an opening, which is defined therein and exposes at least a portion of the second pattern.

According to one or more embodiments of the present disclosure, the common layer included in the light-emitting element may be primarily divided by the tip portions in a region between the dam patterns. In addition, as the upper layer included in each of the dam patterns includes an opening, the common layer may be secondarily divided by the opening. Therefore, moisture and oxygen may be suitably blocked from entering the common layer included in the pixels through the module hole. Accordingly, it is possible to provide the electronic device with improved display quality and improved performance of the electronic module.

Although the above has been described with reference to various embodiments of the present disclosure, those skilled in the art or those of ordinary skill in the art will understand that various modifications and changes can be made to the present disclosure within the scope that does not depart from the technical field of the present disclosure described in the claims to be described later. Accordingly, the present disclosure should not be limited to the content described in the detailed description of the specification, but should be determined by the claims described hereinafter, with functional equivalents thereof to be included therein.

## Claims

1. An electronic device comprising:
a display module including a module hole, and comprising a base layer including a first region surrounded by a second region in plan view, pixels in the second region, data lines connected to the pixels, and dam patterns in the first region and surrounding the module hole in plan view, the dam patterns comprising a first pattern above the base layer, a lower layer above the first pattern, a second pattern above the lower layer and comprising a same material as the data lines, and an upper layer above the second pattern and defining an opening exposing a portion of the second pattern;
a window above the display module; and
an electronic module below the display module, overlapping the first region, and overlapping the module hole.

2. The electronic device of claim 1, wherein a thickness of the upper layer is less than a thickness of the lower layer, and
wherein at least one of opposing sides of the second pattern protrudes between the lower layer and the upper layer.

3. The electronic device of claim 2, wherein the display module further comprises an encapsulation layer covering the pixels and comprising:
a first inorganic encapsulation layer;
a second inorganic encapsulation layer above the first inorganic encapsulation layer; and
an organic encapsulation layer between the first inorganic encapsulation layer and the second inorganic encapsulation layer;
optionally wherein the first inorganic encapsulation layer covers a side surface of the lower layer, a portion of the second pattern protruding between the lower layer and the upper layer, and the side surface and upper surface of the upper layer;
optionally wherein the organic encapsulation layer has a boundary defined by any one of the dam patterns in the first region.

4. The electronic device of any one of claims 1 to 3, wherein the lower layer defines a contact hole exposing at least a portion of the first pattern, and
wherein a portion of the second pattern is in the contact hole and contacts the first pattern.

5. The electronic device of any one of claims 1 to 4, wherein the pixels comprise:
a transistor; and
a light-emitting element comprising a first electrode connected to the transistor, a second electrode above the first electrode, and a common layer between the first electrode and the second electrode.

6. The electronic device of claim 5, further comprising a first floating pattern between the dam patterns adjacent to each other, comprising a same material as the common layer, and disconnected from the common layer;
optionally further comprising a second floating pattern above the upper layer, disconnected from the first floating pattern and the common layer, and comprising a same material as the common layer;
optionally wherein lower layers included in dam patterns spaced apart from each other with the first floating pattern interposed therebetween are connected to each other, and the first floating pattern is disposed on the connected lower layers.

7. The electronic device of claim 6, further comprising a blocking pattern between the dam patterns and dividing the first floating pattern.

8. The electronic device of claim 7, wherein the blocking pattern comprises:
a first layer;
a second layer above the first layer, and comprising a material that is different from a material of the first layer; and
a third layer above the second layer, and comprising the material of the first layer,
wherein the first layer and the third layer protrude in a direction toward the dam patterns further than the second layer.

9. The electronic device of claim 7 or 8, wherein the blocking pattern is provided in plurality, the blocking patterns being spaced apart from each other and surrounding the module hole.

10. The electronic device of any one of claims 7 to 9, wherein the blocking pattern is above connected lower layers of the dam patterns spaced apart from each other with the first floating pattern therebetween.

11. The electronic device of any one of claims 1 to 10, wherein the second pattern and the data lines comprise:
a first layer comprising titanium;
a second layer comprising aluminum above the first layer; and
a third layer comprising titanium above the second layer.

12. The electronic device of claim 11, wherein at least one of opposing sides of the second pattern protrudes between the lower layer and the upper layer, and
wherein the first layer and the third layer protrude in a direction toward the dam patterns further than the second layer.

13. The electronic device of claim 11 or 12, wherein the second pattern defines a hole overlapping the opening, having a groove corresponding to a removed portion of the second layer, and having a pattern opening passing through the third layer and overlapping the groove;
optionally wherein the hole exposes a lower surface of the third layer adjacent to the pattern opening.

14. The electronic device of any one of claims 1 to 13, wherein the pixels comprise a light-emitting element connected to a transistor comprising an active pattern and a gate overlapping the active pattern, and
wherein one of the dam patterns is below and overlaps the first pattern, and further comprises a dummy pattern comprising a same material as the gate or the active pattern.

15. The electronic device of any one of claims 1 to 14, wherein the display module comprises:
a display panel comprising the base layer and the pixels;
an input sensor above the display panel for sensing a user's input;
an organic cover layer above the input sensor; and
an anti-reflective layer between the organic cover layer and the window.
